# EUROPEAN PATENT SPECIFICATION

(11) **EP 2 909 931 B1**
(45) Date of publication and mention of the grant of the patent: **05.12.2018**
(21) Application number: 13846821.0
(22) Date of filing: 21.10.2013
(51) Int. Cl.: H03F 3/60, H03F 3/193

(54) **ENVELOPE TRACKING DISTRIBUTED AMPLIFIER**
KETTENVERSTÄRKER ZUR HÜLLKURVENNACHFÜHRUNG
AMPLIFICATEUR RÉPARTI DE SUIVI D'ENVELOPPE

(30) Priority: 19.10.2012 US 201261716296 P; 24.04.2013 US 201313869737
(43) Date of publication of application: 26.08.2015
(73) Proprietor: Samsung Electronics Co., Ltd., Suwon-si, Gyeonggi-do 443-742 (KR)
(72) Inventor: BROBSTON, Michael, Allen Collin Country, Texas 75013 (US)
(74) Representative: Grünecker Patent- und Rechtsanwälte PartG mbB
(86) International application number: PCT/KR2013/009385
(87) International publication number: WO 2014/062040

(56) References cited:
- KR-A- 20010 059 649
- US-A1- 2002 067 211
- US-A1- 2006 244 536
- US-A1- 2008 024 214
- US-A1- 2010 176 885
- US-A1- 2010 176 885
- US-A1- 2011 223 875
- US-A1- 2012 062 323
- US-B1- 6 433 640

## Description

### Technical Field

The present application relates generally to distributed amplifiers and, more specifically, to an envelope tracking distributed amplifier.

### Background Art

Both wireless mobile devices and infrastructure equipment require power amplifier circuits that operate with high efficiency. The battery life of mobile devices is very dependent on its power amplifier efficiency. The capital cost and operating cost of infrastructure equipment is heavily dependent on its power amplifier efficiency. In the past, much focus has been placed on optimizing the efficiency of the power amplifiers. Using single stage common source transistor circuits or cascaded transistor circuit, the power amplifier is typically matched to a 50 ohm load using a resonant matching network. This type of matching typically results in a relatively narrow bandwidth (-5%) over which the PA operates efficiently and provides adequate gain.

For this reason, multi-band mobile device must employ multiple power amplifiers that are each tuned for peak operation in a different band in order to support roaming demands. Likewise wireless operators are now deploying services simultaneously in multiple bands supporting legacy air interfaces in one band and broadband services such as LTE in a different band. This is forcing infrastructure equipment suppliers to now provide equipment that operates concurrently in multiple bands to avoid excessive redundant transceiver equipment at the cell site. In addition, with the eminent advent of carrier aggregation demands, the need for concurrent multi-band operation in both infrastructure equipment and mobile devices will continue to escalate.

US 2010/176885 A1 refers to a power amplifier using N-way Doherty structure with adaptive bias supply power tracking for extending the efficiency region over the high peak-to-average power ratio of the multiplexing modulated signals such as wideband code division multiple access and orthogonal frequency division multiplexing. In an example, a dual-feed distributed structure is used to an N-way Doherty amplifier to improve the isolation between at least one main amplifier and at least one peaking amplifier, and also to improve both gain and efficiency performance at high output back-off power. Hybrid couplers can be used at either or both of the input and output. In at least some implementations, circuit space is also conserved due to the integration of amplification, power splitting and combining.

US 6 433 640 B1 refers to methods and apparatus of amplifying a telecommunication signal. The apparatus comprises an input transmission line configured to receive the telecommunication signal, an output transmission line configured to provide an amplified output of the telecommunication signal and N amplifier sections having a transistor connected to the input transmission line and the output transmission line. The apparatus further comprises a waveform controller connected to a transistor and also configured to identify a signal level of the telecommunication signal. The waveform controller is further configured to generate an independent biasing voltage for the transistor such that the at least one of the N amplifier sections is configured for active operation and non-active operation based at least in part upon an evaluation of the signal level and an output power of the apparatus is reduced without a substantial degradation in an efficiency of the apparatus.

US 2008/024214 A1 refers to a power amplifier circuit for peak envelope modulation of a high frequency signal. The power amplifier circuit includes a transformer which receives a first signal greater than a predetermined level of an envelope of a carrier signal to generate a transformed signal, and a transistor which operates based on the transformed signal, receives a second signal, which is generated based on the carrier signal and has a direct current component, and amplifies the second signal according to the transformed signal to output an output signal.

US 2006/244536 A1 refers to a non-uniform multi-stage distributed circuit capable of operation with an improved gain-bandwidth product. The circuit can include an input port, an output port and a transmission line coupled therebetween. Two or more amplifier stages can be coupled successively to the transmission line. Each amplifier stage can include a transistor having a transistor parameter, which can be scaled to be less than the transistor parameter of any preceding amplifier stage. The inductance of each portion of the transmission line between adjacent stages can also be scaled to be less than the inductance of the portion of the transmission line between any preceding amplifier stages. The inductance can be scaled in addition to or instead of the transistor parameter.

US 2010/0227577 A1 refers to an apparatus and method for improving linearity of a transmitter. Improvement of linearity of a transmitter is provided, by a transmission method that includes, when receiving a transmit signal, generating, at a modulation signal generator, a modulation signal modulated from the transmit signal, an average output level and an amplitude with respect to the modulation signal; receiving, at a Read Only Memory (ROM), the average output level and generating a peak amplitude; and generating, at an amplitude shaper, a gain value using the peak amplitude and the amplitude and generating magnitude information by adding an offset value.

### Disclosure of the Invention

It is the object of the present invention to provide an improved method for operating an apparatus to amplify an input signal in a wireless network, corresponding base station and mobile station for amplifying an input signal.

This object is solved by the subject matter of the independent claims.

Preferred embodiments are defined in the dependent claims.

A method to amplify a waveform in a wireless network is provided. The method includes detecting an envelope of a waveform to form an envelope waveform. The method also includes shaping the envelope waveform to form a shaped waveform. The shaping is based on one or more characteristics of a distributed amplifier. The method also includes filtering the shaped waveform to form a filtered waveform. The method further includes amplifying the filtered waveform to form a first amplified waveform and amplifying, by the distributed amplifier, at least a part the waveform based on the first amplified waveform to form a second amplified waveform.

A mobile station (MS) configured to amplify a waveform is provided. The MS includes a detector configured to detect an envelope of the waveform to form an envelope waveform. The MS also includes a shaper configured to shape the envelope waveform to form a shaped waveform based on one or more characteristics of a distributed amplifier. The MS also includes a filter configured to filter the shaped waveform to form a filtered waveform. The MS further includes an envelope amplifier configured to amplify the filtered waveform to form a first amplified waveform and a distributed amplifier to amplify the waveform based on the first amplified waveform to form a second amplified waveform.

A base station (BS) configured to amplify a waveform is provided. The BS includes a digital signal processor configured to detect an envelope of the waveform to form an envelope waveform and shape the envelope waveform to form a shaped waveform based on one or more characteristics of a distributed amplifier. The BS also includes a filter configured to filter the shaped waveform to form a filtered waveform. The BS also includes an envelope amplifier configured to amplify the filtered waveform to form a first amplified waveform and a distributed amplifier to amplify the waveform based on the first amplified waveform to form a second amplified waveform.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

### Brief Description of Drawings

For a more complete understanding of the present disclosure and its advantages, reference is now made to the following description taken in conjunction with the accompanying drawings, in which like reference numerals represent like parts:
FIGURE 1 illustrates a wireless network according to embodiments of the present disclosure;
FIGURE 2A illustrates a high-level diagram of a wireless transmit path according to embodiments of the present disclosure;
FIGURE 2B illustrates a high-level diagram of a wireless receive path according to embodiments of the present disclosure;
FIGURE 3 illustrates a subscriber station according to embodiments of the present disclosure;
FIGURE 4 illustrates envelope tracking of a waveform according to embodiments of the present disclosure;
FIGURE 5 illustrates a distributed amplifier according to embodiments of the present disclosure;
FIGURE 6 illustrates a distributed amplifier configured with an envelope tracking path according to embodiments of the present disclosure;
FIGURE 7 illustrates a distributed amplifier configured with an analog envelope tracking architecture according to embodiments of the present disclosure;
FIGURE 8 illustrates a distributed amplifier configured with a digital envelope tracking architecture according to embodiments of the present disclosure;
FIGURE 9 illustrates a distributed amplifier configured with a digital polar architecture according to embodiments of the present disclosure;
FIGURE 10 illustrates a distributed amplifier configured with an analog polar architecture according to embodiments of the present disclosure; and
FIGURE 11 is a flow diagram illustrating amplification of a waveform in a wireless network according to embodiments of the present disclosure.

### Best Mode for Carrying out the Invention

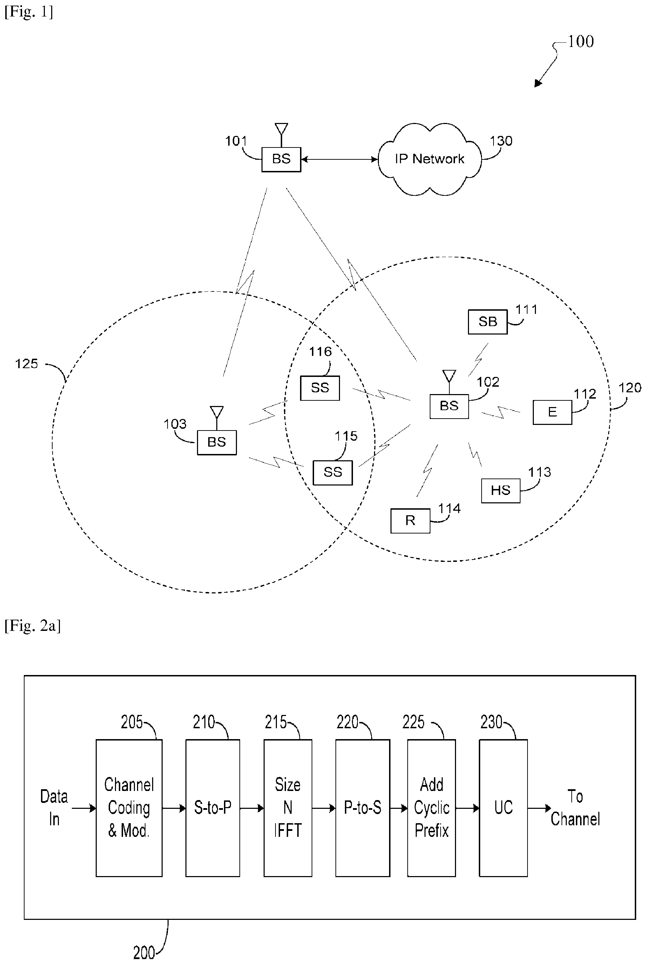

FIGURES 1 through 11, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged amplifier of a wireless network system.

According to the invention , a distributed amplifier is integrated with an envelope tracking path to provide an envelope tracked drain voltage simultaneously to all transistors of the distributed amplifier. In certain embodiments, a distributed amplifier is integrated with a polar transmitter architecture to provide a phase modulated constant amplitude RF drive to the first transistor of the distributed amplifier and simultaneously to provide an envelope tracked drain voltage to all transistors.

Due to the industry changes requiring support for concurrent multi-band operation, global roaming, and Long-Term Evolution (LTE) carrier aggregation, future power amplifier designs will need to support both high efficiency and wideband or concurrent multi-band operation. To support these demands, it is necessary to find a power amplifier architecture that can operate efficiently and have bandwidth potentially in excess of an octave or more. Distributed power amplifier architectures have wide bandwidth operation, but may not be very efficient. The efficiency of the distributed amplifier can be improved using envelope tracking or polar techniques without sacrificing wide bandwidth. The present disclosure describes multiple embodiments of envelope tracking and polar distributed amplifiers implemented either using complete analog architectures or a combination of analog and digital architectures. Also included in the present disclosure is the concept of envelope tracking and polar non-uniform distributed amplifier architectures. These techniques offer significant potential to meeting the daunting efficiency and bandwidth demands of the next generation of wireless power amplifier for both the mobile and infrastructure equipment.

A frequent trade-off in wireless system radio frequency power amplifier design is often between the power added efficiency of the amplifier circuit and its bandwidth. In order to adequately match the output impedance of the power amplifier circuit to that of the load and source impedances, resonant matching networks must be used to transform the impedances. These matching networks are frequently constructed of lumped element components, transmission lines sections, a transformer, or some combination of these.

Typically a power transistor of a power amplifier circuit attains its peak power added efficiency, gain, and output power when terminated with a relatively narrow range of complex source and load impedances and this optimum matching impedance is normally not constant across a wide frequency range. Hence, resonant matching circuits, particularly one or two section matching networks, are often only optimum for power added efficiency over a relatively narrow range of frequencies that is often less than a 5% bandwidth relative to the carrier frequency.

To achieve wider bandwidth operation, multiple matching network sections can be used. Using this technique it is possible to maintain near optimum impedance matching conditions over a larger bandwidth. Since there is a finite insertion loss incurred by each section of the matching network, the tradeoff for wider band operation is often lower gain and lower efficiency.

In modern wireless systems there is increasing pressure to improve both the power added efficiency and the bandwidth of the power amplifiers in the systems. Demand for higher power added efficiency is driven by the need to extended battery life in mobile devices and by the need for reduced capital cost and operating cost in infrastructure equipment. Power amplifier efficiency that is low causes higher electricity usage resulting in higher operating cost. This forces the use of more extensive and expensive cooling features in the equipment thus increasing capital equipment cost.

Wide bandwidth demands on power amplifier circuits in modern wireless systems are being driven by multi-band requirements for support of roaming in mobile devices. LTE carrier aggregation requirements will also drive the need for wideband operation in mobile devices. In infrastructure equipment, wireless operators are increasing operating services concurrently in multiple bands to support legacy air interface while overlaying new spectrum to support newer air interfaces such as LTE. Demand for carrier aggregation capability in infrastructure equipment also continues to increase the need for concurrent multi-band operation of transmitters.

An issue affecting power amplifier efficiency is the peak-to-average ratio of the transmitted waveform. At peak operating power with a continuous waveform (CW) signal, a power amplifier may operate with high efficiency. However, as the output power is reduced, the efficiency drops significantly. Since most waveforms used in modern wireless communication systems (Code Division Multiple Access (CDMA), Wideband Code Division Multiple Access (WCDMA), Worldwide Interoperability for Microwave Access (WiMax), LTE, High Speed Packet Access (HSPA), and the like) have widely fluctuating amplitudes, the average transmitted power must be set with some back-off from the peak to avoid non-linear distortion at the waveform peaks. The amount of back-off required is closely related to the peak-to-average ratio of the transmitted waveform.

FIGURE 1 illustrates a wireless network 100 according to one embodiment of the present disclosure. The embodiment of wireless network 100 illustrated in FIGURE 1 is for illustration only. Other embodiments of wireless network 100 could be used without departing from the scope of this disclosure.

The wireless network 100 includes eNodeB (eNB) 101, eNB 102, and eNB 103. The eNB 101 communicates with eNB 102 and eNB 103. The eNB 101 also communicates with Internet protocol (IP) network 130, such as the Internet, a proprietary IP network, or other data network.

Depending on the network type, other well-known terms may be used instead of "eNodeB," such as "base station" or "access point". For the sake of convenience, the term "eNodeB" shall be used herein to refer to the network infrastructure components that provide wireless access to remote terminals. In addition, the term "user equipment" or "UE" is used herein to designate any remote wireless equipment that wirelessly accesses an eNB and that can be used by a consumer to access services via the wireless communications network, whether the UE is a mobile device (e.g., cell phone) or is normally considered a stationary device (e.g., desktop personal computer, vending machine, etc.). Other well know terms for the remote terminals include "mobile stations" (MS) and "subscriber stations" (SS), "remote terminal" (RT), "wireless terminal" (WT), and the like.

The eNB 102 provides wireless broadband access to network 130 to a first plurality of user equipments (UEs) within coverage area 120 of eNB 102. The first plurality of UEs includes UE 111, which may be located in a small business; UE 112, which may be located in an enterprise; UE 113, which may be located in a WiFi hotspot; UE 114, which may be located in a first residence; UE 115, which may be located in a second residence; and UE 116, which may be a mobile device, such as a cell phone, a wireless laptop, a wireless PDA, or the like. UEs 111-116 may be any wireless communication device, such as, but not limited to, a mobile phone, mobile PDA and any mobile station (MS).

The eNB 103 provides wireless broadband access to a second plurality of UEs within coverage area 125 of eNB 103. The second plurality of UEs includes UE 115 and UE 116. In some embodiments, one or more of eNBs 101-103 may communicate with each other and with UEs 111-116 using 5G, LTE, LTE-A, or WiMAX techniques including techniques for envelope tracking with distributed amplifiers as described in embodiments of the present disclosure.

Dotted lines show the approximate extents of coverage areas 120 and 125, which are shown as approximately circular for the purposes of illustration and explanation only. It should be clearly understood that the coverage areas associated with base stations, for example, coverage areas 120 and 125, may have other shapes, including irregular shapes, depending upon the configuration of the base stations and variations in the radio environment associated with natural and man-made obstructions.

Although FIGURE 1 depicts one example of a wireless network 100, various changes may be made to FIGURE 1. For example, another type of data network, such as a wired network, may be substituted for wireless network 100. In a wired network, network terminals may replace eNBs 101-103 and UEs 111-116. Wired connections may replace the wireless connections depicted in FIGURE 1.

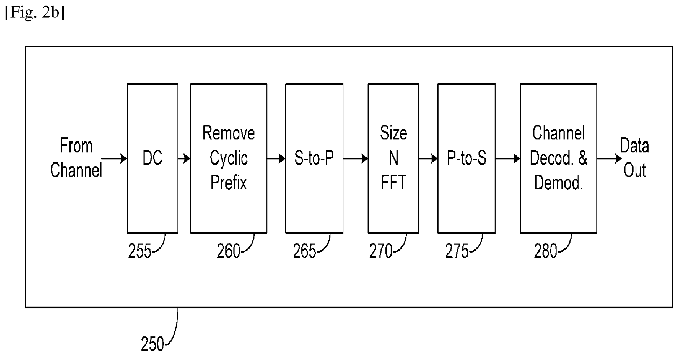

FIGURE 2A is a high-level diagram of a wireless transmit path. FIGURE 2B is a high-level diagram of a wireless receive path. In FIGURES 2A and 2B, the transmit path 200 may be implemented, e.g., in eNB 102 and the receive path 250 may be implemented, e.g., in a UE, such as UE 116 of FIGURE 1. It will be understood, however, that the receive path 250 could be implemented in an eNB (e.g. eNB 102 of FIGURE 1) and the transmit path 200 could be implemented in a UE. In certain embodiments, transmit path 200 and receive path 250 are configured to perform methods for envelope tracking distributed amplifiers as described in embodiments of the present disclosure.

Transmit path 200 comprises channel coding and modulation block 205, serial-to-parallel (S-to-P) block 210, Size N Inverse Fast Fourier Transform (IFFT) block 215, parallel-to-serial (P-to-S) block 220, add cyclic prefix block 225, up-converter (UC) 230. Receive path 250 comprises down-converter (DC) 255, remove cyclic prefix block 260, serial-to-parallel (S-to-P) block 265, Size N Fast Fourier Transform (FFT) block 270, parallel-to-serial (P-to-S) block 275, channel decoding and demodulation block 280.

At least some of the components in FIGURES 2A and 2B may be implemented in software while other components may be implemented by configurable hardware (e.g., a processor) or a mixture of software and configurable hardware. In particular, it is noted that the FFT blocks and the IFFT blocks described in this disclosure document may be implemented as configurable software algorithms, where the value of Size N may be modified according to the implementation.

Furthermore, although this disclosure is directed to an embodiment that implements the Fast Fourier Transform and the Inverse Fast Fourier Transform, this is by way of illustration only and should not be construed to limit the scope of the disclosure. It will be appreciated that in an alternate embodiment of the disclosure, the Fast Fourier Transform functions and the Inverse Fast Fourier Transform functions may easily be replaced by Discrete Fourier Transform (DFT) functions and Inverse Discrete Fourier Transform (IDFT) functions, respectively. It will be appreciated that for DFT and IDFT functions, the value of the N variable may be any integer number (i.e., 1, 2, 3, 4, etc.), while for FFT and IFFT functions, the value of the N variable may be any integer number that is a power of two (i.e., 1, 2, 4, 8, 16, etc.).

In transmit path 200, channel coding and modulation block 205 receives a set of information bits, applies coding (e.g., LDPC coding) and modulates (e.g., Quadrature Phase Shift Keying (QPSK) or Quadrature Amplitude Modulation (QAM)) the input bits to produce a sequence of frequency-domain modulation symbols. Serial-to-parallel block 210 converts (i.e., de-multiplexes) the serial modulated symbols to parallel data to produce N parallel symbol streams where N is the IFFT/FFT size used in eNB 102 and UE 116. Size N IFFT block 215 then performs an IFFT operation on the N parallel symbol streams to produce time-domain output signals. Parallel-to-serial block 220 converts (i.e., multiplexes) the parallel time-domain output symbols from Size N IFFT block 215 to produce a serial time-domain signal. Add cyclic prefix block 225 then inserts a cyclic prefix to the time-domain signal. Finally, up-converter 230 modulates (i.e., up-converts) the output of add cyclic prefix block 225 to RF frequency for transmission via a wireless channel. The signal may also be filtered at baseband before conversion to RF frequency.

The transmitted RF signal arrives at UE 116 after passing through the wireless channel and reverse operations to those at eNB 102 are performed. Down-converter 255 down-converts the received signal to baseband frequency and remove cyclic prefix block 260 removes the cyclic prefix to produce the serial time-domain baseband signal. Serial-to-parallel block 265 converts the time-domain baseband signal to parallel time domain signals. Size N FFT block 270 then performs an FFT algorithm to produce N parallel frequency-domain signals. Parallel-to-serial block 275 converts the parallel frequency-domain signals to a sequence of modulated data symbols. Channel decoding and demodulation block 280 demodulates and then decodes the modulated symbols to recover the original input data stream.

Each of eNBs 101-103 may implement a transmit path that is analogous to transmitting in the downlink to UEs 111-116 and may implement a receive path that is analogous to receiving in the uplink from UEs 111-116. Similarly, each one of UEs 111-116 may implement a transmit path corresponding to the architecture for transmitting in the uplink to eNBs 101-103 and may implement a receive path corresponding to the architecture for receiving in the downlink from eNBs 101-103.

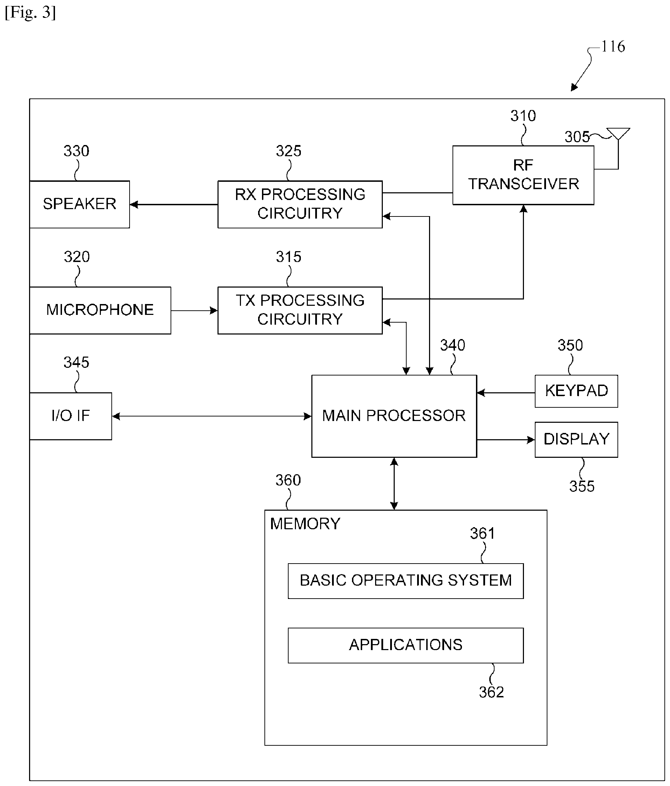

FIGURE 3 illustrates a mobile station according to embodiments of the present disclosure. The embodiment of the mobile station, such as UE 116, illustrated in FIGURE 3 is for illustration only. Other embodiments of the wireless mobile station could be used without departing from the scope of this disclosure.

UE 116 comprises antenna 305, radio frequency (RF) transceiver 310, transmit (TX) processing circuitry 315, microphone 320, and receive (RX) processing circuitry 325. Although shown as a single antenna, antenna 305 can include multiple antennas. SS 116 also comprises speaker 330, main processor 340, input/output (I/O) interface (IF) 345, keypad 350, display 355, and memory 360. Memory 360 further comprises basic operating system (OS) program 361 and a plurality of applications 362. The plurality of applications can include one or more of resource mapping tables (Tables 1-10 described in further detail herein below).

Radio frequency (RF) transceiver 310 receives from antenna 305 an incoming RF signal transmitted by a base station of wireless network 100. Radio frequency (RF) transceiver 310 down-converts the incoming RF signal to produce an intermediate frequency (IF) or a baseband signal. The IF or baseband signal is sent to receiver (RX) processing circuitry 325 that produces a processed baseband signal by filtering, decoding, and/or digitizing the baseband or IF signal. Receiver (RX) processing circuitry 325 transmits the processed baseband signal to speaker 330 (i.e., voice data) or to main processor 340 for further processing (e.g., web browsing).

Transmitter (TX) processing circuitry 315 receives analog or digital voice data from microphone 320 or other outgoing baseband data (e.g., web data, e-mail, interactive video game data) from main processor 340. Transmitter (TX) processing circuitry 315 encodes, multiplexes, and/or digitizes the outgoing baseband data to produce a processed baseband or IF signal. Radio frequency (RF) transceiver 310 receives the outgoing processed baseband or IF signal from transmitter (TX) processing circuitry 315. Radio frequency (RF) transceiver 310 up-converts the baseband or IF signal to a radio frequency (RF) signal that is transmitted via antenna 305.

In certain embodiments, main processor 340 is a microprocessor or microcontroller. Memory 360 is coupled to main processor 340. According to some embodiments of the present disclosure, part of memory 360 comprises a random access memory (RAM) and another part of memory 360 comprises a Flash memory, which acts as a read-only memory (ROM).

Main processor 340 executes basic operating system (OS) program 361 stored in memory 360 in order to control the overall operation of wireless subscriber station 116. In one such operation, main processor 340 controls the reception of forward channel signals and the transmission of reverse channel signals by radio frequency (RF) transceiver 310, receiver (RX) processing circuitry 325, and transmitter (TX) processing circuitry 315, in accordance with well-known principles and including techniques for envelope tracking with distributed amplifiers as described in embodiments of the present disclosure.

Main processor 340 is capable of executing other processes and programs resident in memory 360. Main processor 340 can move data into or out of memory 360, as required by an executing process. In some embodiments, the main processor 340 is configured to execute a plurality of applications 362, such as applications for CoMP communications and MU-MIMO communications. The main processor 340 can operate the plurality of applications 362 based on OS program 361 or in response to a signal received from BS 102. Main processor 340 is also coupled to I/O interface 345. I/O interface 345 provides subscriber station 116 with the ability to connect to other devices such as laptop computers and handheld computers. I/O interface 345 is the communication path between these accessories and main controller 340.

Main processor 340 is also coupled to keypad 350 and display unit 355. The operator of subscriber station 116 uses keypad 350 to enter data into subscriber station 116. Display 355 may be a liquid crystal display capable of rendering text and/or at least limited graphics from web sites. Alternate embodiments may use other types of displays.

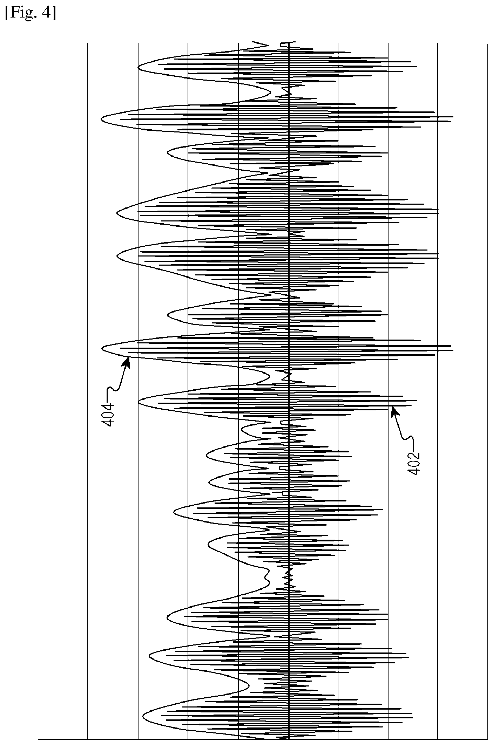

FIGURE 4 illustrates envelope tracking of a waveform according to the invention . Envelope tracking is a technique for achieving improved efficiency in power amplifier. As depicted, waveform 404 is the drain or collector voltage of the final active device, and in some cases the prior driver stage(s). Waveform 404 varies roughly proportionally to the instantaneous waveform envelope level of a modulated radio frequency (RF) waveform 402. Using this technique, less power is dissipated in a power transistor when the instantaneous envelope power is below the peak operating power of the transistor. Envelope tracking techniques are being broadly deployed in infrastructure transmitters to reduce the operating cost and capital cost of the equipment through efficiency improvements. The efficiency of the power amplifier is overwhelmingly the largest single factor in the base station power consumption and the base station thermal design, therefore the efficiency improvement realized using envelope tracking is clearly an advantage. Likewise in the wireless mobile devices, there is much industry activity to deploy envelope tracking power amplifiers to enhance the battery life while still supporting high order modulation waveforms.

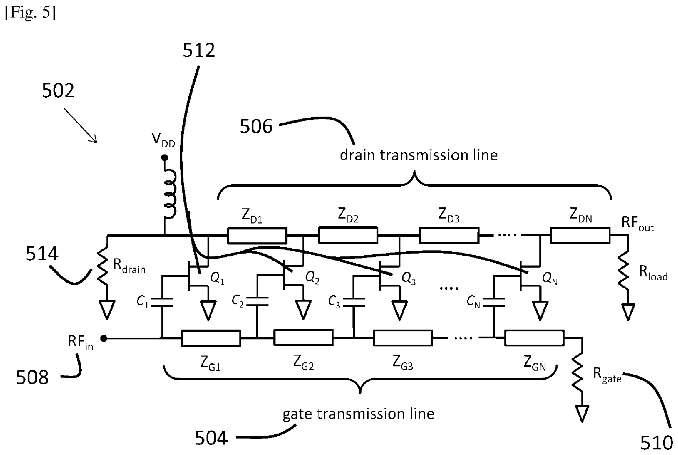

FIGURE 5 illustrates a distributed amplifier according to an exemplary embodiment of the disclosure. Although the greater focus within the wireless industry has been on power amplifier improvements, with greater demands for wideband and concurrent multi-band operation in wireless mobile devices and infrastructure equipment, there is increasing attention toward widening the operating frequency range of the transmitter power amplifiers. For applications such as military electronic warfare systems and optical networks, an amplifier architecture used to achieve a greater gain-bandwidth product is called the distributed amplifier or traveling wave amplifier. In the distributed amplifier architecture, multiple transistor devices are configured in a parallel array effectively with one transmission line to distribute the input signal to the gate or base of each transistor and another artificial transmission line used to coherently combine the amplified drain or collector signals of all of the devices.

By combining the input and output networks of the transistors using transmission line, it is possible to absorb the input and output capacitance of the active devices as part of an artificial transmission line thereby providing a broadband response. The transmission lines are coupled by the transconductances of the transistor stages to provide a relatively flat, low-pass response across a wide bandwidth. This is in contrast to a cascade amplifier architecture in which the device input and output capacitance is transformed using a resonant circuit which has a natural narrow bandpass response. A distributed amplifier can often provide in excess of a decade of instantaneous bandwidth. However, the power added efficiency of the distributed amplifier does not often compare well to a single or cascaded common-source circuit.

The amplifier architecture can be implemented either using field effect transistors (FET) or bipolar junction transistors (BJT). Therefore in further descriptions of the circuit any reference to the transistor drain refers to both the drain of an FET or the collector of a BJT. Likewise, any reference to the transistor gate refers to both the gate of an FET or the base of a BJT.

As in FIGURE 5, a distributed amplifier 502 includes two transmission lines. The first transmission line is gate line 504, also referred to as gate transmission line. The second transmission line is drain line 506, also referred to as drain transmission line. Waveform 508, also referred to as signal and RFᵢₙ, is an RF signal that is applied to gate line 504. Waveform 508 may correspond to waveform 402 of FIGURE 4. The drain voltage, V_{DD}, may correspond to waveform 404 of FIGURE 4. Waveform 508 propagates down the gate line 504 and is terminated by resistive load 510 (also referred to as R_{gate}) to minimize reflection of waveform 508. As signal 508 propagates down gate transmission line 504, each transistor 512 amplifies the signal 508 through its transconductance onto drain transmission line 506. The signal from each transistor 512 propagated down the drain transmission line 506 add coherently in a forward direction under the condition that phase velocities on the gate line 504 and drain line 506 are identical for all transistors 512. The signals from the transistor drains on the drain transmission line 506 traveling in the reverse direction are out of phase and will therefore cancel. Any residual signal in the reverse direction that is not cancelled will be absorbed by the drain transmission line termination 514, also referred to as R_{drain}.

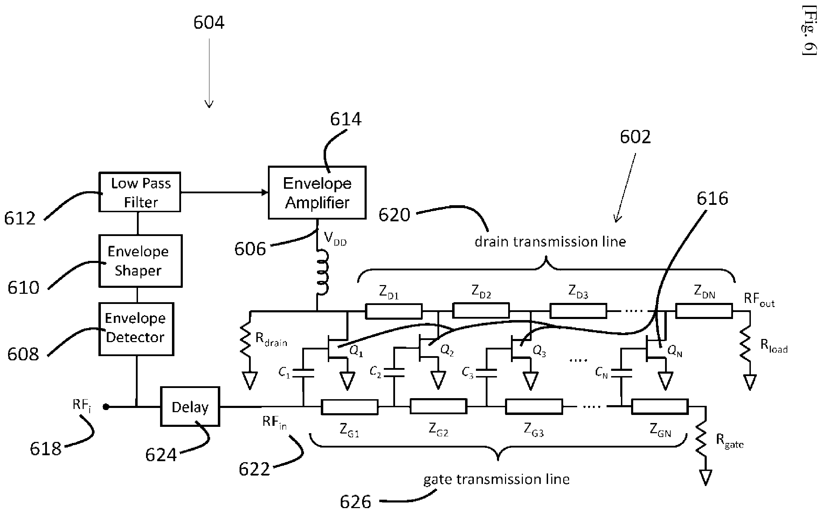

FIGURE 6 illustrates a distributed amplifier 602 configured with an envelope tracking path 604 according to an exemplary embodiment of the disclosure. Envelope tracking path 604 is attached to a common drain or collector line 606 in order to simultaneously achieve higher efficiency and wide bandwidth operation. As shown in FIGURE 6, this is accomplished by first detecting a waveform envelope of the input signal 618 (also referred to as RFᵢ) via envelope detector 608 and then appropriately shaping the waveform via envelope shaper 610 and filtering the waveform via low pass filter 612 to achieve optimum out-of-band noise, adjacent channel power ratio (ACPR), and efficiency. The resulting waveform from low pass filter 612 is then amplified using envelope amplifier 614, also referred to as EA 614. EA 614 is effectively a high efficiency, high bandwidth driver that provides the drain or collector of the distributed amplifier 602 transistors 616 with a voltage that instantaneously tracks the envelope level of the input signal 618 with sufficient current source capability matched to the requirements of the distributed amplifier transistors 616. Since all transistors 616 within the distributed amplifier 602 receive a drain or collector bias from a common current supply, a single EA 614 is able to modulate this voltage to all of the transistors 616 simultaneously. In certain descriptions of distributed amplifiers, the drain voltage, V_{DD}, is a constant DC voltage.

Since the drain voltage at line 606 is distributed to the amplifier transistors 616 across drain transmission line 620, some expected delay of several carrier cycles from the first transistor (Q₁) in the array of transistors 616 to the last(Q_{N}) occurs. Yet since the bandwidth of the envelope is expected to be a fraction of the carrier frequency, several carrier cycles of delay should not significantly impact the ACLR or efficiency of the distributed amplifier 602.

Input signal 618 is delayed via delay 624 before being applied as waveform 622 (also referred to as RFᵢₙ) to distributed amplifier 602. Delay 624 allows for the output of envelope amplifier 614 to be properly synchronized with waveform 622.

In the envelope tracking distributed amplifier of FIGURE 6, the array of transistors 616 comprises a plurality of transistors configured in a parallel configuration. The minimum number of transistor stages is two, but larger arrays are also included within the scope of the present disclosure. In general, fewer number of transistor stages will result in higher gain and power added efficiency, but lower bandwidth. Conversely, a greater number of transistor stages will result in lower gain and power added efficiency, but higher bandwidth. Distributed amplifiers may have greater than a decade of bandwidth using ten transistor stages.

In certain embodiments, all the transistors 616 are scaled identically and the impedance of transmission lines 620 and 626 is designed to be constant across the entire length of transmission lines 620 and 626. This is considered a uniform envelope tracking distributed amplifier. Due to a natural taper in a signal's amplitude as it propagates across the gate transmission line 626, subsequent transistor stages receive decreasing levels of gate drive. If the optimum load impedance of the final stage based on its drive level is designed for appropriate matching to a typical 50 ohm resistive load, then use of the same drain transmission line impedance for the initial transistor stages which receive high drive level will result in sub-optimal gain and power added efficiency for the initial stages.

A technique to optimize the load characteristics seen by each transistor stage involves tapering of the characteristic impedances of sections of drain transmission line 620 in order to maintain an optimum load presented to each transistor stage. In addition, another technique used is to combine drain transmission line impedance taper with transistor device sizing such that some transistor stages have larger periphery and some have smaller periphery scaled to provide optimum gain and efficiency performance into reduced transmission line impedances. This architecture is known as a non-uniform distributed amplifier. In certain embodiments of this disclosure, the envelope amplifier is combined with a non-uniform distributed amplifier architecture to further enhance the gain and power added efficiency of the envelope track distributed amplifier implementation. The envelope tracking non-uniform distributed amplifier architecture is also illustrated in FIGURE 6, but in this case sections Z_{D1} through Z_{DN} of drain transmission line 620 are not of equal characteristic impedance. Other techniques may also be implemented within the non-uniform envelope tracking distributed amplifier such as tapering of the series gate capacitor values for subsequent transistor stages in order to equalize the RF drive voltage provided to the gates of transistors 616.

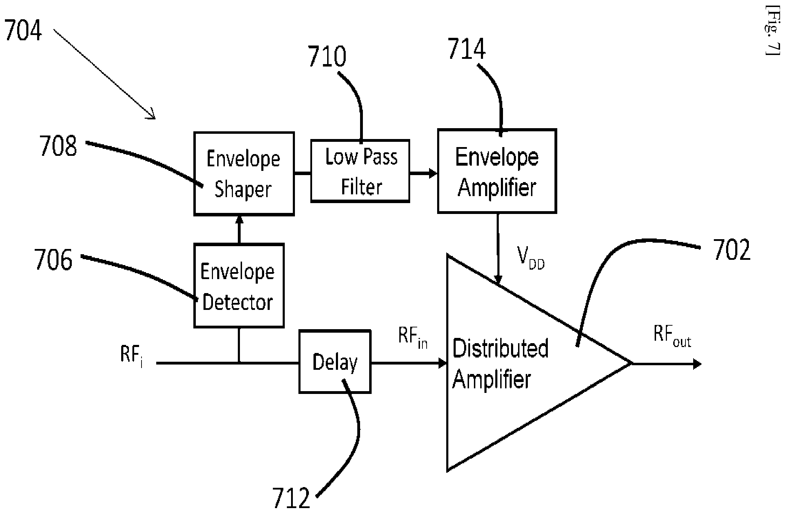

FIGURE 7 illustrates a distributed amplifier 702 configured with an analog envelope tracking architecture according to an exemplary embodiment of the disclosure. The envelope tracking path 704 of the analog envelope tracking architecture is implemented entirely using analog circuit blocks as illustrated in FIGURE 7 in which the envelope detector 706, envelope shaper 708, low pass filter 710, delay element 712, and envelope amplifier 714 are constructed with analog circuits, which may be programmable analog circuits. Use of the analog envelope tracking architecture of the embodiment of FIGURE 7 may be advantageous in MSs so that amplification of the waveform may be done without modification to a baseband processor of the MS. In this architecture either the uniform distributed amplifier or the non-uniform distributed amplifier can be used. The non-uniform distributed amplifier used on the polar architecture may provide better gain and efficiency.

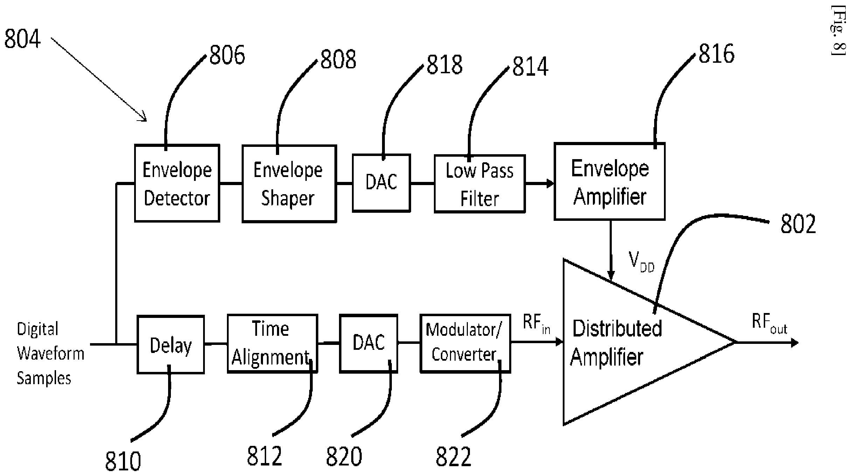

FIGURE 8 illustrates a distributed amplifier 802 configured with a digital envelope tracking architecture according to an exemplary embodiment of the disclosure. The envelope tracking path 804 of digital envelope tracking architecture can be implemented using a combination of digital and analog blocks as illustrated in FIGURE 8. In this illustration the envelope detector 806, envelope shaper 808, delay element 810, and time alignment 812 are implemented using digital circuits, such as a baseband processor or a digital signal processor, whereas the low pass filter 814 and envelope amplifier 816 remain predominately analog circuits. Digital to analog converters (DACs) 818 and 820 are used to convert between the digital circuits and analog circuits. Modulator/converter 822 converts the output from DAC 820 into a modulated signal to be amplified by distributed amplifier 802. Use of the digital envelope tracking architecture of the embodiment of FIGURE 8 may be advantageous in BSs to provide greater accuracy and flexibility in the envelope detector and shaping and time alignment in order to optimize power amplifier efficiency and modulation accuracy. In this architecture, the digital functions could be implemented either by a digital signal processor, digital logic circuits, or some combination of these. In this architecture either the uniform distributed amplifier or the non-uniform distributed amplifier can be used. The non-uniform distributed amplifier used on the polar architecture may provide better gain and efficiency.

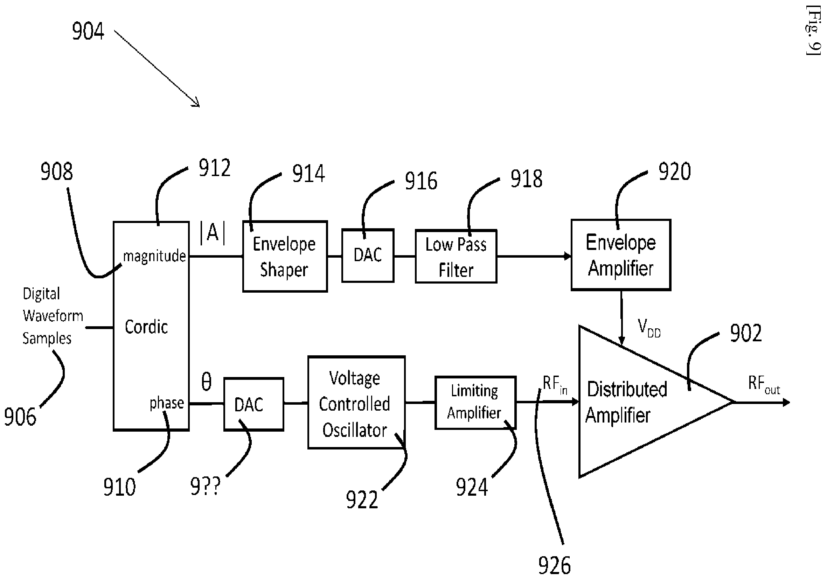

FIGURE 9 illustrates a distributed amplifier configured with a digital polar architecture according to an exemplary embodiment of the disclosure. In certain embodiments, a distributed amplifier 902 is integrated with a polar amplifier architecture 904. An alternate reference to the polar architecture is envelope elimination and restoration. In this architecture the digital signal in the form of digital waveform samples 906 is split into a magnitude component 908 and a phase component. This is commonly done using a Coordinate Rotation Digital Computer (Cordic) function in digital signal process block 912. Magnitude component 908, also referred to as magnitude element 908 and IAI, is used to drive the envelope tracking path comprising an envelope shaper 914, digital to analog converter 916, low pass filter 918, and envelope amplifier 920. Phase component 910, also referred to as phase signal 910 and Θ, is converted from digital to analog by DAC 928 and is used to phase modulate an oscillator, such as voltage controlled oscillator 922 that generates the carrier tone. The carrier tone is driven into a saturated or limiting amplifier 924 to produce a constant amplitude, phase modulated RF carrier that is used as the input to distributed amplifier 902. This allows distributed amplifier 902 to be driven at its peak efficiency over the full waveform dynamic range. This phase modulated waveform 926, also referred to as RFin, then receives amplitude modulation through the envelope tracking drain voltage applied by EA 920 to distributed amplifier 902. In this architecture either the uniform distributed amplifier or the non-uniform distributed amplifier can be used. The non-uniform distributed amplifier used on the polar architecture may provide better gain and efficiency.

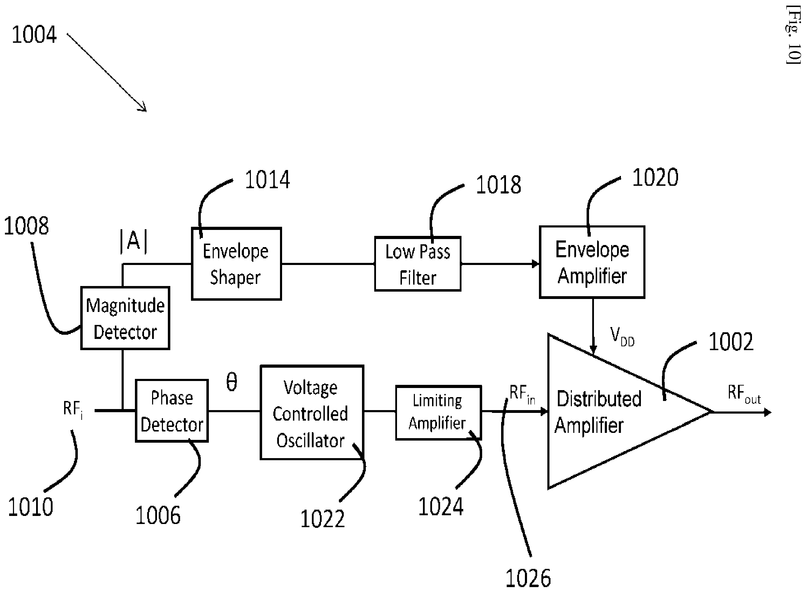

FIGURE 10 illustrates a distributed amplifier configured with an analog polar architecture according to an exemplary embodiment of the disclosure. In this embodiment, a distributed amplifier 1002 is integrated with a polar drive architecture 1004. In this architecture the analog signal in the form of RFᵢ 1010 is split into a magnitude component via magnitude detector 1008 and a phase component via phase detector 1006. The magnitude component, also referred to as IAI, and is used to drive the envelope tracking path comprising an envelope shaper 1014, low pass filter 1018, and envelope amplifier 1020. The phase component, also referred to as Θ, is used to phase modulate an oscillator, such as voltage controlled oscillator 1022 that generates the carrier tone. The carrier tone is driven into a saturated or limiting amplifier 1024 to produce a constant amplitude, phase modulated RF carrier that is used as the input to distributed amplifier 1002. This allows distributed amplifier 1002 to be driven at its peak efficiency over the full waveform dynamic range. This phase modulated waveform 1026, also referred to as RFᵢₙ, then receives amplitude modulation through the envelope tracking drain voltage applied by EA 1020 to distributed amplifier 1002. In this architecture either the uniform distributed amplifier or the non-uniform distributed amplifier can be used. The non-uniform distributed amplifier used on the polar architecture may provide better gain and efficiency.

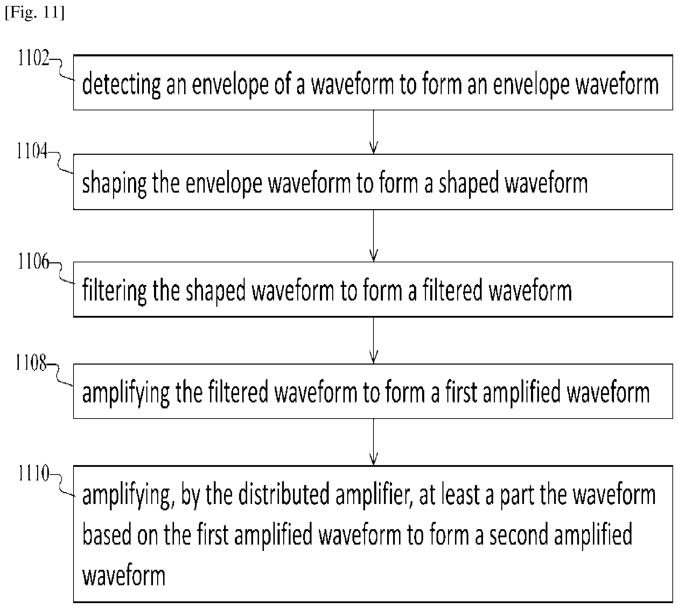

FIGURE 11 is a flow diagram illustrating amplification of a waveform in a wireless network according to an exemplary embodiment of the disclosure. The amplification uses an envelope amplifier to drive a distributed amplifier, as shown in FIGURE 6. At 1102, an envelope of a waveform is detected to form an envelope waveform. The waveform can be an analog signal or a digital signal in the form of digital waveform samples and is an embodiment of signal 402 of FIGURE 4. The envelope of the waveform may correspond to a full wave rectification of the waveform with additional smoothing, such as via a capacitive element or the like. The envelope waveform is an output of a digital or analog envelope detector that performs the detection of the envelope.

At 1104, the envelope waveform is shaped to form a shaped waveform. The shaping is based on one or more characteristics of a distributed amplifier to which a second amplified waveform, which is based on the shaped waveform, will be applied. The one or more characteristics of the distributed amplifier for which the envelope waveform is shaped includes a minimum drain voltage of the distributed amplifier, a linearity of the distributed amplifier, a gain variation behavior of the distributed amplifier over the dynamic range, a required Error Vector Magnitude (EVM) and Adjacent Channel Power Ratio (ACPR) for the applicable air interface standard, and the like. The shaped waveform is an output of a digital or analog envelope shaper that performs the detection of the envelope.

At 1106, the shaped waveform is filtered to form a filtered waveform. The filtering removes noise or distortion introduced by one or more other components or steps, such as detecting the envelope and converting the shaped waveform from digital to analog. For example, when using an analog envelope tracking architecture as in FIGURE 7, envelope detector 406 may introduce wideband noise and distortion that are filtered out by low pass filter 410. As another example, when using a digital envelope tracking architecture as in FIGURE 5, the digital to analog converter 406 may introduce wideband image products that are filtered out by low pass filter 410. Hence, the filtering may be based on the other components in the system and may be based on the type of system. The shaped waveform is an input to a filter and the filtered waveform is an output of the filter that performs the filtering.

At 1108, the filtered waveform is amplified to form a first amplified waveform. This first amplification amplifies the signal so as to drive a distributed amplifier. The filtered waveform may be an input to an envelope amplifier and the first amplified waveform is an output of the envelope amplifier.

At 1110, at least part of the waveform is amplified based on the first amplified waveform to form a second amplified waveform. This second amplification amplifies the signal to be ready for transmission via an antenna. The second amplification modifies each of a plurality of transistors of the distributed amplifier with the second amplified waveform. The at least part of the waveform and the first amplified waveform is input to a distributed amplifier and the second amplified waveform
is an output of the distributed amplifier. The second amplified waveform is transmitted and is an input to an antenna.

An alternative embodiment of the method of FIGURE 11 includes processing the initial waveform to form a magnitude waveform and a phase waveform. In this embodiment, the magnitude waveform is used as an envelope waveform, as described above, and the phase waveform is the part of the waveform amplified by the distributed amplifier, as described above.

In embodiments of the present disclosure, the envelope tracking distributed amplifier can be implemented using Gallium Nitride (GaN), Gallium Arsenide (GaAs), Silicon-Germanium SiGe, Indium Gallium Phosphide (InGaP), Laterally Diffused Metal Oxide Semiconductor (LDMOS), or even Complementary metal-oxide-semiconductor (CMOS) transistor technology, although the highest power added efficiency and widest bandwidth will likely be achieved using GaN transistors due to the higher breakdown voltage and electron mobility of this technology. Initial estimates indicate implementation of an envelope tracking distributed amplifier or polar distributed amplifier using GaN device technology in a non-uniform topology would possibly provide power added efficiencies that are greater than 30 to 35% for a modulated waveform having a PAR of up to 6 dB operating over several octaves of bandwidth. While tuned single stage envelope tracking amplifiers have been demonstrated to achieve a PAE of up to 50%, this is only possible over a relatively narrow tuned bandwidth of about 5%. Therefore while the envelope tracking distributed amplifier presented in this disclosure will likely not match the PAE of the tuned envelope tracking amplifier, it can provide substantially greater gain-bandwidth product to support wideband or concurrent multi-band wireless applications while still operating with sufficient power added efficiency to support required battery life and operating expense requirements of wireless networks.

Although the present disclosure has been described with an exemplary embodiment, various changes and modifications may be suggested to one skilled in the art. It is intended that the present disclosure encompass such changes and modifications as fall within the scope of the appended claims.

## Claims

1. A method for operating an apparatus to amplify an input signal (906, 1010) in a wireless network, the method comprising:
detecting (1102) a magnitude waveform (908, 1008) and a phase waveform (910, 1006) from a waveform of the input signal (906, 1010);
generating a shaped signal by performing an envelope shaping (1104) to the magnitude waveform (908, 1008) based on characteristics for a distributed amplifier (902, 1002) in the apparatus;
generating a filtered signal by filtering (1106) the shaped signal;
generating a first signal by amplifying (1108) the filtered signal, wherein the first signal is used to provide a drain voltage or a collector voltage to a plurality of transistors in the distributed amplifier (902, 1002);
generating a phase modulated waveform with a constant amplitude by performing phase modulation to the phase waveform (910, 1006), the phase modulated waveform in which a radio frequency, RF, carrier is used as an input of the distributed amplifier (902, 1002);
generating a second signal by amplifying (1110), by the distributed amplifier (902, 1002), the phase modulated waveform; and
transmitting the second signal,
wherein the characteristics of the distributed amplifier (902, 1002) for which the magnitude waveform (908, 1008) is shaped include a minimum drain voltage of the distributed amplifier (902, 1002), a linearity of the distributed amplifier, and a gain variation behavior of the distributed amplifier (902, 1002) over a dynamic range.

2. The method of claim 1, wherein the filtering (1106) removes noise caused by one or more of the detecting and converting the shaped signal from digital to analog.

3. A base station, BS, for amplifying an input signal (906, 1010), the BS comprising:
a detector (908, 1006, 1008) configured to detect a magnitude waveform (908, 1008) and a phase waveform (910, 1006) from a waveform of the input signal (906, 1010);
a shaper (914, 1014) configured to generate a shaped signal by performing an envelope shaping (1104) to the magnitude waveform (908, 1008) based on one or more characteristics for a distributed amplifier (902, 1002) in the BS;
a filter (918, 1018) configured to generate a filtered signal by filtering (1106) the shaped signal;
an envelope amplifier (920, 1020) configured to generate a first signal by amplifying (1108) the filtered signal, wherein the first signal is used to provide a drain voltage or a collector voltage to a plurality of transistors in the distributed amplifier (902, 1002);
a limiting amplifier (924, 1024) configured to generate a phase modulated waveform with a constant amplitude by performing phase modulation to the phase waveform, the phase modulated waveform in which a radio frequency, RF, carrier is used as an input of the distributed amplifier (902, 1002);
the distributed amplifier (902, 1002) configured to generate a second signal by amplifying (1110) the phase modulated waveform; and
a transmitter configured to transmit the second signal,
wherein the characteristics of the distributed amplifier (902, 1002) for which the magnitude waveform (908, 1008) is shaped include a minimum drain voltage of the distributed amplifier (902, 1002), a linearity of the distributed amplifier (902, 1002), and a gain variation behavior of the distributed amplifier (902, 1002) over a dynamic range.

4. The BS of claim 3, wherein the filter removes noise caused by the detector (908, 1006) or a digital to analog conversion of the shaped signal.

5. A mobile station, MS, for amplifying an input signal (906, 1010), the MS comprising:
a processor configured to:
detect a magnitude waveform (908, 1008) and a phase waveform (910, 1006) from a waveform of the input signal (906, 1010); and
generate a shaped signal by performing an envelope shaping (1104) to the magnitude waveform (908, 1008) based on one or more characteristics for a distributed amplifier (902, 1002) in the MS;
a filter (918, 1018) configured to generate a filtered signal by filtering (1106) the shaped signal;
an envelope amplifier (920, 1020) configured to generate a first signal by amplifying (1108) the filtered signal, wherein the first signal is used to provide a drain voltage or a collector voltage to a plurality of transistors in the distributed amplifier (902, 1002);
a limiting amplifier (924, 1024) configured to generate a phase modulated waveform with a constant amplitude by performing phase modulation to the phase waveform, the phase modulated waveform in which a radio frequency, RF, carrier is used as an input of the distributed amplifier (902, 1002);
the distributed amplifier (902, 1002) configured to generate a second signal by amplifying (1110) the phase modulated waveform; and
a transmitter configured to transmit the second signal,
wherein the characteristics of the distributed amplifier (902, 1002) for which the magnitude waveform (908, 1008) is shaped include a minimum drain voltage of the distributed amplifier (902, 1002), a linearity of the distributed amplifier (902, 1002), and a gain variation behavior of the distributed amplifier (902, 1002) over a dynamic range.

6. The MS of claim 5, wherein the filter removes noise caused by the processor or a digital to analog conversion of the shaped signal.

## Patentansprüche

1. Betriebsverfahren für eine Vorrichtung zur Verstärkung eines Eingangssignals (906, 1010) in einem drahtlosen Netzwerk, wobei das Verfahren umfasst:
Ermitteln (1102) einer Größenwellenform (908, 1008) und einer Phasenwellenform (910, 1006) aus einer Wellenform des Eingangssignals (906, 1010);
Erzeugen eines geformten Signals durch Durchführen einer Hüllkurvenformgebung (1104) an der Größenwellenform (908, 1008) basierend auf Charakteristiken für einen Kettenverstärker (902, 1002) in der Vorrichtung;
Erzeugen eines gefilterten Signals durch Filtern (1106) des geformten Signals;
Erzeugen eines ersten Signals durch Verstärken (1108) des gefilterten Signals, wobei das erste Signal dazu verwendet wird, eine Drain-Spannung oder eine Kollektorspannung für eine Vielzahl von Transistoren in dem Kettenverstärker (902, 1002) bereitzustellen;
Erzeugen einer phasenmodulierten Wellenform mit einer konstanten Amplitude durch Durchführen von Phasenmodulation an der Phasenwellenform (910, 1006), wobei in der phasenmodulierten Wellenform ein Funkfrequenz-, RF-, Träger als Eingang des Kettenverstärkers (902, 1002) verwendet wird;
Erzeugen eines zweiten Signals durch Verstärken (1110), durch den Kettenverstärker (902, 1002), der phasenmodulierten Wellenform; und
Senden des zweiten Signals,
wobei die Charakteristiken des Kettenverstärkers (902, 1002), für den die Größenwellenform (908, 1008) geformt ist, eine Mindest-Drain-Spannung des Kettenverstärkers (902, 1002), eine Linearität des Kettenverstärkers und ein Verstärkungsänderungsverhalten des Kettenverstärkers (902, 1002) über einen Lautstärkebereich beinhalten.

2. Verfahren nach Anspruch 1, wobei das Filtern (1106) Rauschen entfernt, das durch eines oder mehrere aus Ermitteln und Konvertieren des geformten Signals von digital nach analog verursacht wird.

3. Basisstation, BS, zum Verstärken eines Eingangssignals (906, 1010), wobei die BS umfasst:
einen Detektor (908, 1006, 1008), der dazu konfiguriert ist, eine Größenwellenform (908, 1008) und eine Phasenwellenform (910, 1006) aus einer Wellenform des Eingangssignals (906, 1010) zu ermitteln;
einen Formgeber (914, 1014), der dazu konfiguriert ist, ein geformtes Signal durch Durchführen einer Hüllkurvenformgebung (1104) an der Größenwellenform (908, 1008) basierend auf einer oder mehreren Charakteristiken für einen Kettenverstärker (902, 1002) in der BS zu erzeugen;
einen Filter (918, 1018), der dazu konfiguriert ist, einen gefiltertes Signal durch Filtern (1106) des geformten Signals zu erzeugen;
einen Hüllkurvenverstärker (920, 1020), der dazu konfiguriert ist, ein erstes Signal durch Verstärken (1108) des gefilterten Signals zu erzeugen, wobei das erste Signal dazu verwendet wird, eine Drain-Spannung oder eine Kollektorspannung für eine Vielzahl von Transistoren in dem Kettenverstärker (902, 1002) bereitzustellen;
einen Begrenzungsverstärker (924, 1024), der dazu konfiguriert ist, eine phasenmodulierte Wellenform mit einer konstanten Amplitude durch Durchführen von Phasenmodulation an der Phasenwellenform zu erzeugen, wobei in der phasenmodulierten Wellenform ein Funkfrequenz-, RF-, Träger als Eingang des Kettenverstärkers (902, 1002) verwendet wird;
wobei der Kettenverstärker (902, 1002) dazu konfiguriert ist, ein zweites Signal durch Verstärken (1110) der phasenmodulierten Wellenform zu erzeugen; und
einen Sender, der dazu konfiguriert ist, das zweite Signal zu senden,
wobei die Charakteristiken des Kettenverstärkers (902, 1002), für den die Größenwellenform (908, 1008) geformt ist, eine Mindest-Drain-Spannung des Kettenverstärkers (902, 1002), eine Linearität des Kettenverstärkers (902, 1002) und ein Verstärkungsänderungsverhalten des Kettenverstärkers (902, 1002) über einen Lautstärkebereich beinhalten.

4. BS nach Anspruch 3, wobei der Filter Rauschen entfernt, das durch den Detektor (908, 1006) oder eine Digital-Analog-Umwandlung des geformten Signals verursacht wird.

5. Mobilstationen, MS, zum Verstärken eines Eingangssignals (906, 1010), wobei die MS umfasst:
einen Prozessor, der zu Folgendem konfiguriert ist:
Ermitteln einer Größenwellenform (908, 1008) und einer Phasenwellenform (910, 1006) aus einer Wellenform des Eingangssignals (906, 1010); und
Erzeugen eines geformten Signals durch Durchführen einer Hüllkurvenformgebung (1104) an der Größenwellenform (908, 1008) basierend auf einer oder mehreren Charakteristiken für einen Kettenverstärker (902, 1002) in der MS;
einen Filter (918, 1018), der dazu konfiguriert ist, einen gefiltertes Signal durch Filtern (1106) des geformten Signals zu erzeugen;
einen Hüllkurvenverstärker (920, 1020), der dazu konfiguriert ist, ein erstes Signal durch Verstärken (1108) des gefilterten Signals zu erzeugen, wobei das erste Signal dazu verwendet wird, eine Drain-Spannung oder eine Kollektorspannung für eine Vielzahl von Transistoren in dem Kettenverstärker (902, 1002) bereitzustellen;
einen Begrenzungsverstärker (924, 1024), der dazu konfiguriert ist, eine phasenmodulierte Wellenform mit einer konstanten Amplitude durch Durchführen von Phasenmodulation an der Phasenwellenform zu erzeugen, wobei in der phasenmodulierten Wellenform ein Funkfrequenz-, RF-, Träger als Eingang des Kettenverstärkers (902, 1002) verwendet wird;
wobei der Kettenverstärker (902, 1002) dazu konfiguriert ist, ein zweites Signal durch Verstärken (1110) der phasenmodulierten Wellenform zu erzeugen; und
einen Sender, der dazu konfiguriert ist, das zweite Signal zu senden,
wobei die Charakteristiken des Kettenverstärkers (902, 1002), für den die Größenwellenform (908, 1008) geformt ist, eine Mindest-Drain-Spannung des Kettenverstärkers (902, 1002), eine Linearität des Kettenverstärkers (902, 1002) und ein Verstärkungsänderungsverhalten des Kettenverstärkers (902, 1002) über einen Lautstärkebereich beinhalten.

6. MS nach Anspruch 5, wobei der Filter Rauschen entfernt, das durch den Prozessor oder eine Digital-Analog-Umwandlung des geformten Signals verursacht wird.

## Revendications

1. Procédé d'exploitation d'un appareil pour amplifier un signal d'entrée (906, 1010) dans un réseau sans fil, le procédé comprenant les étapes suivantes:
détecter (1102) une forme d'onde de magnitude (908, 1008) et une forme d'onde de phase (910, 1006) à partir d'une forme d'onde du signal d'entrée (906, 1010);
générer un signal mis en forme en effectuant une mise en forme d'enveloppe (1104) pour obtenir la forme d'onde d'amplitude (908, 1008) sur la base de caractéristiques pour un amplificateur distribué (902, 1002) dans l'appareil;
générer un signal filtré en filtrant (1106) le signal formé;
générer un premier signal en amplifiant (1108) le signal filtré, dans lequel le premier signal est utilisé pour fournir une tension de drain ou une tension de collecteur à une pluralité de transistors dans l'amplificateur distribué (902, 1002);
générer une forme d'onde modulée en phase avec une amplitude constante en effectuant une modulation de phase sur la forme d'onde de phase (910, 1006), la forme d'onde modulée en phase dans laquelle une porteuse radiofréquence RF est utilisée comme entrée de l'amplificateur distribué (902, 1002);
générer un second signal en amplifiant (1110), par l'amplificateur distribué (902, 1002), la forme d'onde modulée en phase; et
transmettre le second signal,
dans lequel les caractéristiques de l'amplificateur distribué (902, 1002), pour lesquelles la forme d'onde d'amplitude (908, 1008) est formée, comprennent une tension de drain minimum de l'amplificateur distribué (902, 1002), une linéarité de l'amplificateur distribué et un comportement de variation de gain de l'amplificateur distribué (902, 1002) sur une plage dynamique.

2. Procédé selon la revendication 1, dans lequel le filtrage (1106) supprime le bruit provoqué par un ou plus de la détection et la conversion du signal formé de numérique en analogique.

3. Station de base, BS, pour amplifier un signal d'entrée (906, 1010), la station de base comprenant:
un détecteur (908, 1006, 1008) pour détecter une forme d'onde de magnitude (908, 1008) et une forme d'onde de phase (910, 1006) à partir d'une forme d'onde du signal d'entrée (906, 1010);
un dispositif de mise en forme (914, 1014) configuré pour générer un signal mis en forme en effectuant une mise en forme d'enveloppe (1104) pour obtenir la forme d'onde d'amplitude (908, 1008) sur la base d'une ou plusieurs caractéristiques pour un amplificateur distribué (902, 1002) dans la station de base;
un filtre (918, 1018) configuré pour générer un signal filtré en filtrant (1106) le signal formé;
un amplificateur d'enveloppe (920, 1020) configuré pour générer un premier signal en amplifiant (1108) le signal filtré, dans lequel le premier signal est utilisé pour fournir une tension de drain ou une tension de collecteur à une pluralité de transistors dans l'amplificateur distribué (902, 1002);
un amplificateur limiteur (924, 1024) configuré pour générer une forme d'onde modulée en phase avec une amplitude constante en effectuant une modulation de phase sur la forme d'onde de phase, la forme d'onde modulée en phase dans laquelle une porteuse radiofréquence RF est utilisée comme entrée de l'amplificateur distribué (902, 1002);
l'amplificateur distribué (902, 1002) configuré pour générer un second signal en amplifiant (1110) la forme d'onde modulée en phase; et
un émetteur configuré pour transmettre le second signal,
dans lequel les caractéristiques de l'amplificateur distribué (902, 1002), pour lesquelles la forme d'onde d'amplitude (908, 1008) est formée, comprennent une tension de drain minimum de l'amplificateur distribué (902, 1002), une linéarité de l'amplificateur distribué et un comportement de variation de gain de l'amplificateur distribué (902, 1002) sur une plage dynamique.

4. Station de base selon la revendication 3, dans laquelle le filtre élimine le bruit provoqué par le détecteur (908, 1006) ou une conversion numérique-analogique du signal formé.

5. Station mobile, MS, pour amplifier un signal d'entrée (906, 1010), la station mobile comprenant:
un processeur configuré pour:
détecter une forme d'onde de magnitude (908, 1008) et une forme d'onde de phase (910, 1006) à partir d'une forme d'onde du signal d'entrée (906, 1010);
générer un signal mis en forme en effectuant une mise en forme d'enveloppe (1104) pour obtenir la forme d'onde d'amplitude (908, 1008) sur la base de caractéristiques pour un amplificateur distribué (902, 1002) dans la station mobile;
un filtre (918, 1018) configuré pour générer un signal filtré en filtrant (1106) le signal formé;
un amplificateur d'enveloppe (920, 1020) configuré pour générer un premier signal en amplifiant (1108) le signal filtré, dans lequel le premier signal est utilisé pour fournir une tension de drain ou une tension de collecteur à une pluralité de transistors dans l'amplificateur distribué (902, 1002);
un amplificateur limiteur (924, 1024) configuré pour générer une forme d'onde modulée en phase avec une amplitude constante en effectuant une modulation de phase sur la forme d'onde de phase, la forme d'onde modulée en phase dans laquelle une porteuse radiofréquence RF est utilisée comme entrée de l'amplificateur distribué (902, 1002);
l'amplificateur distribué (902, 1002) configuré pour générer un second signal en amplifiant (1110) la forme d'onde modulée en phase; et
un émetteur configuré pour transmettre le second signal,
dans lequel les caractéristiques de l'amplificateur distribué (902, 1002), pour lesquelles la forme d'onde d'amplitude (908, 1008) est formée, comprennent une tension de drain minimum de l'amplificateur distribué (902, 1002), une linéarité de l'amplificateur distribué et un comportement de variation de gain de l'amplificateur distribué (902, 1002) sur une plage dynamique.

6. Station mobile selon la revendication 5, dans lequel le filtre élimine le bruit provoqué par le processeur ou une conversion numérique-analogique du signal formé.
